(19)

Europäisches
Patentamt
European
Patent Office
Office européen
des brevets

(11) **EP 4 614 410 A1**

(12) **EUROPEAN PATENT APPLICATION**

(43) Date of publication:
**10.09.2025 Bulletin 2025/37**

(21) Application number: **25155970.4**

(22) Date of filing: **05.02.2025**

(51) International Patent Classification (IPC):
*G06Q 10/0631* (2023.01)

(52) Cooperative Patent Classification (CPC):
**G06Q 10/06312**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.03.2024 JP 2024036212**

(71) Applicant: **FUJITSU LIMITED**
**Kawasaki-shi, Kanagawa 211-8588 (JP)**

(72) Inventors:
• **YAMADA, Hiroaki**
  **Kawasaki-shi, Kanagawa, 211-8588 (JP)**
• **YAMANE, Shohei**
  **Kawasaki-shi, Kanagawa, 211-8588 (JP)**
• **TAKAHASHI, Tetsuro**
  **Kawasaki-shi, Kanagawa, 211-8588 (JP)**

(74) Representative: **Hoffmann Eitle**
**Patent- und Rechtsanwälte PartmbB**
**Arabellastraße 30**
**81925 München (DE)**

(54) **OPERATION SCHEDULE SPECIFYING PROGRAM, METHOD AND APPARATUS**

(57) An information processing apparatus receives data for a plurality of social measures that is a consideration target, detects a prediction model constructed from a trained neural network for substituting a simulation related to social measures by using machine learning, performs, based on characteristics of the prediction model, a filtering processing on the data for the plurality of social measures, performs the simulation on data for one or more of the social measures extracted by the filtering processing, specifies, based on a result of the simulation performed on the data for the one or more social measures, a first social measure that is an implementation target from among the plurality of social measures that is the consideration target, and outputs the first social measure.

FIG.6

**Description**

FIELD

The embodiments discussed herein are related to a measure specifying program, a measure specifying method, and an information processing apparatus.

BACKGROUND

A measure analysis is needed in various situations, and becomes more sophisticated by using a social simulation that is one example of a simulation. For example, an example of the measure analysis includes, in a situation of deciding an operation schedule of a special bus at the time of an event, in order for an operator of a social infrastructure to find out an operation schedule capable of preventing an occurrence of or an increase in congestion, to consider advantages and disadvantages by listing options of various settings of departure and arrival time and the like obtained by changing the settings.

Furthermore, the social simulation is a simulation that is simulated in the form in which a social system, such as a traffic system, is able to be calculated, and it is possible to quantitatively evaluate a measure and allows the measure analysis to be more sophisticated by using the social simulation. However, it takes a long calculation time to obtain the social simulation, so that it is difficult to optimize the measure by comprehensively evaluating the measure and finding out an optimum measure.

In recent years, there is a known surrogate model that is one example of an alternative model that is a substitution for a simulation and whose accuracy is lower than that of the simulation but the calculation time of the alternative model is short. Furthermore, as a technology for generating the surrogate model for a complicated social simulation, there is a known technology for using, as the surrogate model, a trained model that has been obtained by training a large amount of social data by using a neural network.

Patent Document 1: Japanese Laid-open Patent Publication No. 2023-113928
Patent Document 2: Japanese Laid-open Patent Publication No. 2021-157456
Patent Document 3: Japanese Laid-open Patent Publication No. 2022-3451
Patent Document 4: U.S. Patent Application Publication No. 2018/0112498

However, it is difficult to find out an optimum measure by using the surrogate model, such as the above described surrogate model. For example, with the surrogate model, it is possible to comprehensively evaluate a measure in a short time, but is not always possible to find out a good measure because the accuracy of the surrogate model is lower than that of the simulation.

Accordingly, it is an object in one aspect of an embodiment of the present invention to provide a measure specifying program, a measure specifying method, and an information processing apparatus capable of improving selection accuracy of a measure.

SUMMARY

According to an aspect of an embodiment, a non-transitory computer-readable recording medium stores therein a measure specifying program that causes a computer to execute a process including receiving (S101) data for a plurality of social measures that is a consideration target, detecting (S102) a prediction model constructed from a trained neural network for substituting a simulation related to social measures by using machine learning, performing (S102, S103, S104), based on characteristics of the prediction model, a filtering processing on the data for the plurality of social measures, performing (S105) the simulation on data for one or more of the social measures extracted by the filtering processing, specifying (S107), based on a result of the simulation performed on the data for the one or more social measures, a first social measure that is an implementation target from among the plurality of social measures that is the consideration target, and outputting (S107) the first social measure.

BRIEF DESCRIPTION OF DRAWINGS

FIG. 1 is a diagram illustrating an information processing apparatus that performs optimization of a measure;
FIG. 2 is a diagram illustrating a simulation;
FIG. 3 is a diagram illustrating a prediction obtained by the simulation;

FIG. 4 is a diagram illustrating a surrogate model;

FIG. 5 is a diagram illustrating a prediction obtained by the surrogate model;

FIG. 6 is a diagram illustrating a measure optimization system performed by the information processing apparatus according to a first embodiment;

FIG. 7 is a functional block diagram illustrating a functional configuration of the information processing apparatus according to the first embodiment;

FIG. 8 is a diagram illustrating a training of the surrogate model;

FIG. 9 is a diagram illustrating a prediction process;

FIG. 10 is a diagram illustrating a pre-filtering process performed by using the surrogate model;

FIG. 11 is a diagram illustrating a pre-filtering process performed by using the surrogate model;

FIG. 12 is a diagram illustrating a process for specifying a measure by using a simulation;

FIG. 13 is a flowchart illustrating the flow of the measure optimization system;

FIG. 14 is a diagram illustrating an example of an augmentation of learning data that is commonly used for the surrogate model;

FIG. 15 is a diagram illustrating a learning process 1 for enhancing the accuracy of the surrogate model;

FIG. 16 is a diagram illustrating a learning process 2 for enhancing the accuracy of the surrogate model;

FIG. 17 is a diagram illustrating an example using a digital twin; and

FIG. 18 is a diagram illustrating an example of a hardware configuration.

## DESCRIPTION OF EMBODIMENTS

Preferred embodiments will be explained with reference to accompanying drawings. Furthermore, the present invention is not limited to the embodiments. In addition, each of the embodiments may be used in any appropriate combination as long as they do not conflict with each other.

(a) First Embodiment

Explanation of information processing apparatus 10

An information processing apparatus 10 according to a first embodiment is one example of a computer that executes a measure optimization system for specifying an optimum measure from among a plurality of measures. In the present embodiment, an example of a process for specifying, in a situation of deciding an operation schedule of a special bus at the time of an event, an optimum measure (operation schedule) capable of preventing an occurrence of or an increase in congestion from among each of the operation schedules that are the plurality of measures.

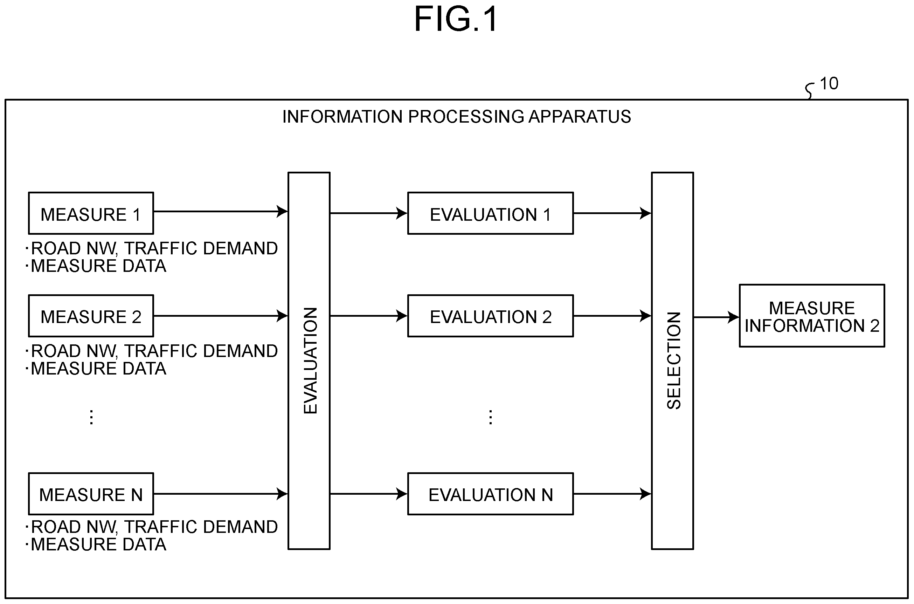

FIG. 1 is a diagram illustrating the information processing apparatus that performs optimization of a measure. As illustrated in FIG. 1, the information processing apparatus 10 evaluates measures denoted by a measure 1 to a measure N (N is a natural number) each of which includes a road network, a traffic demand, and measure data by using a surrogate model (hereinafter, sometimes referred to as a SM) or a social simulation (hereinafter, sometimes referred to as a simulation or a SIM). Then, the information processing apparatus 10 specifies at least one piece of measure information from the obtained evaluation result.

Furthermore, the road network indicates a configuration of a road that is an execution target for the measure, and is one example of a predetermined area included in the road configuration. The traffic demand is one example of a prediction value of the traffic demand in the predetermined area, and is, for example, an Origin-Destination (OD) table that indicates a forecast value of a travel demand between each of points. The measure data is one example of a candidate for the measure that is applied in the predetermined area, and is, for example, a traffic measure, such as an OD table, that indicates an operation schedule of a special bus operated at the time of an event, and is a measure for resolving a congestion degree of the traffic in the predetermined area.

In the following, a simulation of a social measure and a surrogate model that have been used to evaluate a measure for a long time will be described.

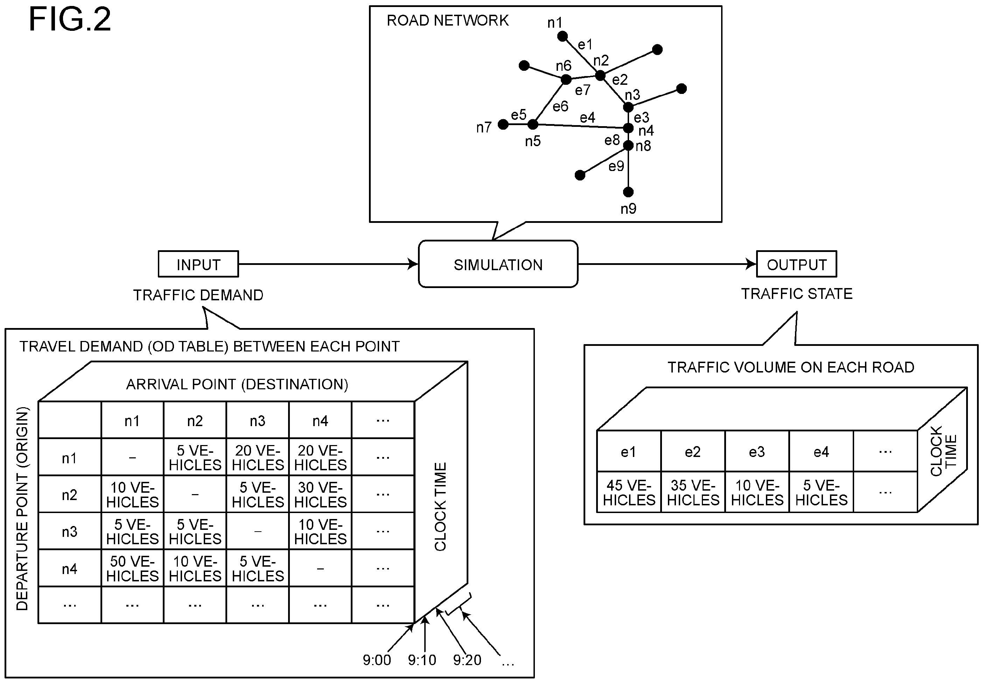

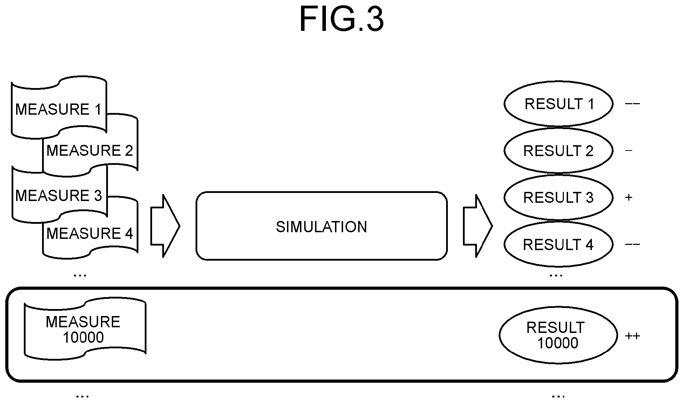

FIG. 2 is a diagram illustrating a simulation, and FIG. 3 is a diagram illustrating a prediction obtained by the simulation. As illustrated in FIG. 2, the simulation simulates a traffic volume of each link in a road network by inputting a travel demand (OD table) between each of base points, which are set by using a departure point, an arrival point, and clock time as dimensions, and a road network, and then outputs a traffic volume (OD table) of each of the links in the respective time zones as the simulation results. Furthermore, the road network is constituted by a node that is denoted by n1, or the like and a link that indicates between nodes and that is denoted by e1, or the like.

Then, as illustrated in FIG. 3, from among a lowest evaluation grade "--", a low evaluation grade "-", a high evaluation grade "+", and a highest evaluation grade "++" that are evaluations that are assigned to the respective measures and that are output by the simulation, a "measure 10000" that is the highest evaluation grade is specified.

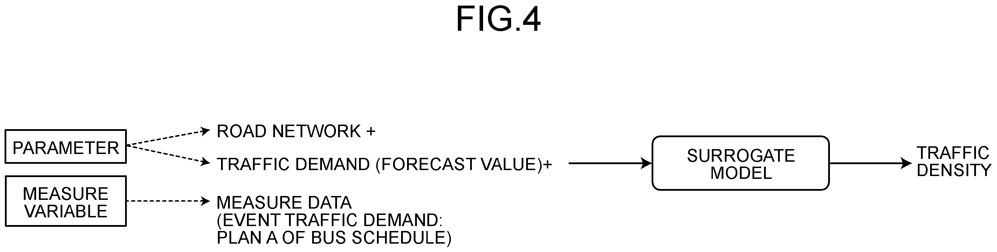

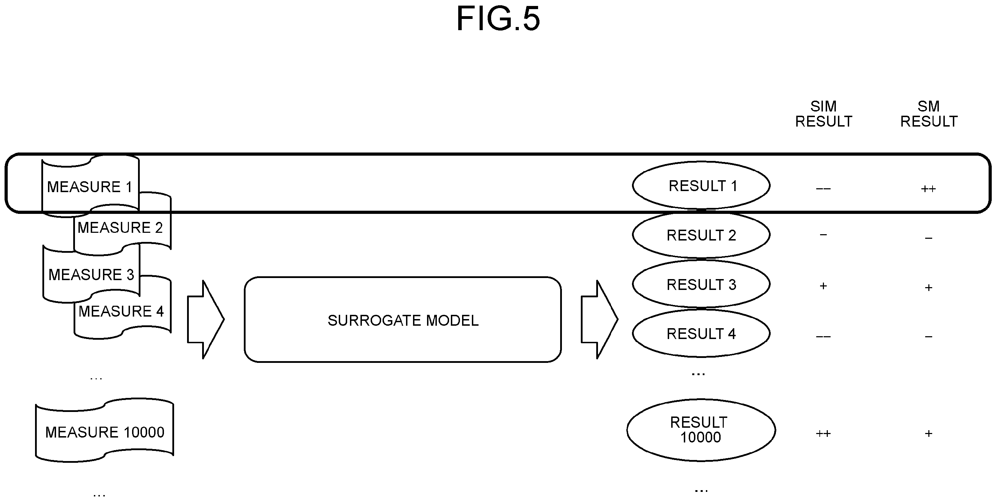

In contrast, FIG. 4 is a diagram illustrating a surrogate model, and FIG. 5 is a diagram illustrating a prediction obtained by the surrogate model. As illustrated in FIG. 4, the surrogate model is a trained neural network, or the like, and outputs a traffic density of each of the links in accordance with the inputs of parameters of "a road network and a traffic demand" and a measure variable of "measure data (for example, an event traffic demand)".

Then, as illustrated in FIG. 5, the surrogate model specifies the "measure 1" that is the highest evaluation grade from among the lowest evaluation grade "--", the low evaluation grade "-", the high evaluation grade "+", and the highest evaluation grade "++" that are evaluations that are assigned to the respective measures and that are output by the surrogate model.

FIG. 5 illustrates both of the result (SIM result) obtained in the case where the same measures are simulated and a determination result (SM result) obtained by the surrogate model, but the determination results of the optimum measure are different between these results. Specifically, in the simulation, it is determined that the measure 1 corresponding to the lowest evaluation grade is an optimum measure in the surrogate model. Such a phenomenon arises from a low reliability of the surrogate model that depends on learning data.

In other words, the simulation is able to specify an optimum measure, but needs unrealistic calculation time to consider all of the measures. The surrogate model is able to reduce the calculation time, but is less accuracy, so that it is not always possible to select an optimum measure. Therefore, it is hard to say that both of the simulation and the surrogate model are optimum methods. A hurdle is too high for the measure that is not able to fail, such as a social measure, to use both of the simulation and the surrogate model.

Accordingly, the information processing apparatus 10 according to the first embodiment implements both of a speeding up of a process and high accuracy by performing pre-filtering focused on the characteristic that is exhibited by the surrogate model that has been trained by supervised learning and that indicates that "the performance of the surrogate model is low in an area corresponding to out of distribution of the learning data, but the performance of the surrogate model is high in an area corresponding to in distribution of the learning data". Specifically, the accuracy of the surrogate model is generally lower than that of the simulation, but, in particular, the surrogate model has the characteristic in that significant performance degradation occurs in the area corresponding to out of distribution of the learning data, which is a point of focus. In FIG. 5, general degradation of accuracy is an error indicating that it is determined that, for example, the measure having the highest evaluation grade is a high evaluation grade (The result 10000 indicated in FIG. 5. Prediction is not able to be performed with a level of sufficient detail), and the significant performance degradation is an error indicating that it is determined that, for example, the measure corresponding to the lowest evaluation grade is the highest evaluation grade (the result 1 indicated in FIG. 5. A meaningful prediction is not able to be performed).

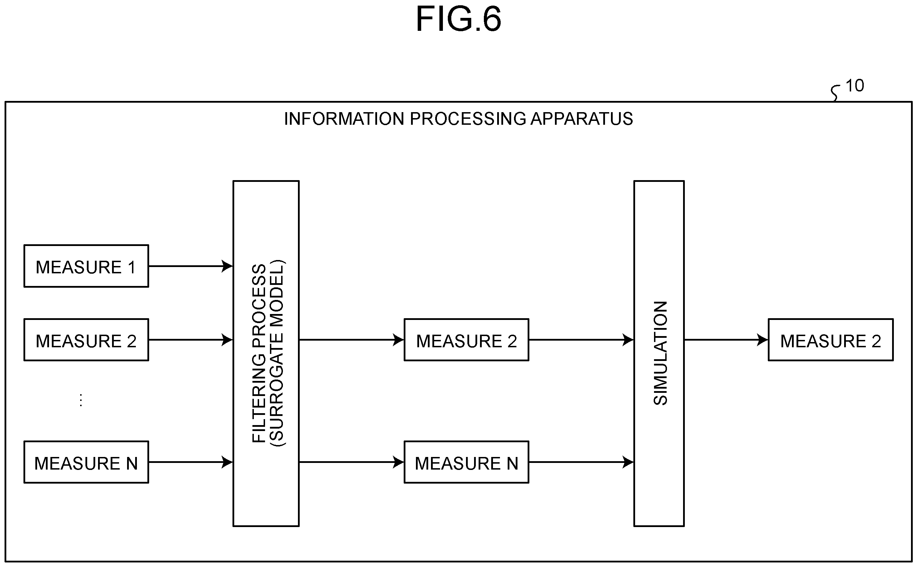

FIG. 6 is a diagram illustrating a measure optimization system performed by the information processing apparatus 10 according to the first embodiment. In the measure optimization system, first, the information processing apparatus 10 performs a filtering process on a plurality of social measures each of which corresponds to a consideration target on the basis of the characteristic of the prediction model. Then, the information processing apparatus 10 specifies, on the basis of the result obtained from the simulation of one or more social measures that are subjected to the filtering process, from among the plurality of social measures corresponding to the consideration targets, the social measure that corresponds to the implementation target. Furthermore, the prediction model is a model that is used to substitute the simulation by using machine learning. The prediction model is, for example, a surrogate model.

In other words, the information processing apparatus 10 uses the machine learning model used for substituting the simulation, and specifies one or more social measures that have been subjected to the filtering process from among the plurality of social measures that are the consideration targets. More specifically, the information processing apparatus 10 uses the machine learning model that has been trained to simulate the simulation, and specifies one or more social measures that are subjected to the filtering process from among the plurality of social measures that are the consideration targets.

Subsequently, the information processing apparatus 10 specifies a social measure that is an implementation target on the basis of the simulated simulation from among one or more social measures that have been subjected to the filtering process. More specifically, the information processing apparatus 10 performs the filtering process by using the trained machine learning model, and specifies the social measure that is the implementation target on the basis of the simulation related to one or more social measures.

Furthermore, as illustrated in FIG. 6, the information processing apparatus 10 performs the filtering process on a plurality of the measure 1, a measure 2, ..., and a measure N that are the consideration targets by using the surrogate model, or the like. Then, the information processing apparatus 10 performs a simulation on one or more measures that have been subjected to the filtering process, and specifies, on the basis of the result obtained from the simulation, the social measure that is the implementation target from among the plurality of measures that are the consideration targets. Furthermore, in FIG. 6, the one or more measures that have been subjected to the filtering process correspond to the measure 2 and the measure N. Then, the social measure that is the implementation target corresponds to the measure 2.

Furthermore, for example, the learning data mentioned here is past data, the area in distribution of the learning data mentioned here is an interpolation area that is within a range of the past trend, and the area out of distribution of the learning data mentioned here is an extrapolation area that is a range away from the past trend. The information processing apparatus 10 evaluates the measure that belongs to the interpolation area by using the surrogate model and the simulation, and evaluates the measure that belongs to the extrapolation area by using only the simulation.

In this way, the information processing apparatus 10 is able to find out an optimum measure in a short time by coping with both of the accuracy and the calculation efficiency by using different evaluation methods among the respective measures that are the consideration targets in accordance with the interpolation area and the extrapolation area.

Functional Configuration

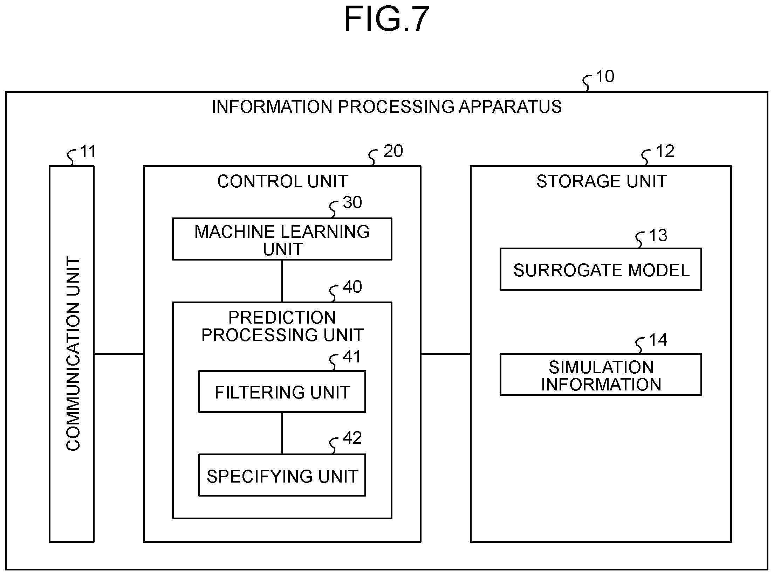

FIG. 7 is a functional block diagram illustrating a functional configuration of the information processing apparatus 10 according to the first embodiment. As illustrated in FIG. 7, the information processing apparatus 10 includes a communication unit 11, a storage unit 12, and a control unit 20.

The storage unit 12 is one example of a processing unit that stores therein various kinds of data, a program executed by the control unit 20, or the like, and is implemented by, for example, a memory, a hard disk, or the like. The storage unit 12 stores therein a surrogate model 13 and a simulation information 14. Furthermore, the storage unit 12 is able to store the learning data that is used to train the surrogate model 13.

The surrogate model 13 is a neural network, or the like that outputs a traffic density of each of the links in the road network in accordance with an input of the parameter of "a road network and a traffic demand" and a measure variable (event traffic demand). Furthermore, the surrogate model 13 may be trained by another device.

The simulation information 14 is various kinds of information that are used to perform the social simulation. For example, the simulation information 14 is information related to a mathematical expression, a parameter, information on a road network, or the like. A traffic simulator that is one example of the social simulation is performed by using the simulation information 14.

The control unit 20 is a processing unit that manages the entirety of the information processing apparatus 10, and is implemented by, for example, a processor, or the like. The control unit 20 includes a machine learning unit 30 and a prediction processing unit 40. Furthermore, the machine learning unit 30 and the prediction processing unit 40 are implemented by an electronic circuit that is included in a processor or implemented by a process or the like that is executed by the processor.

The machine learning unit 30 is a processing unit that generates the surrogate model 13. Specifically, the machine learning unit 30 performs training (learning) on the surrogate model 13 by supervised learning, and generates the surrogate model 13 that outputs the traffic density of each of the links included in the road network.

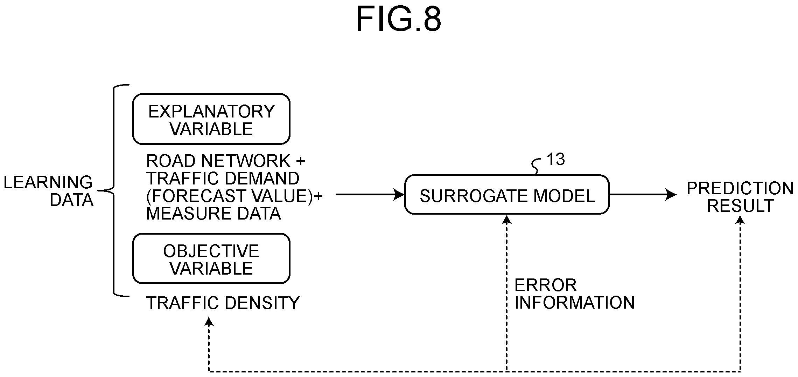

FIG. 8 is a diagram illustrating a training of the surrogate model 13. As illustrated in FIG. 8, the machine learning unit 30 inputs, to the surrogate model 13, the learning data in which a combination of "a road network, a traffic demand, and measure data" is used as an explanatory variable and the "traffic density" is used as an objective variable, and acquires the prediction result obtained by the surrogate model 13. Then, the machine learning unit 30 generates the surrogate model 13 by updating the parameter for the surrogate model 13 (neural network) such that an error between the prediction result obtained by the surrogate model 13 and the objective variable of the "traffic density".

As a more specific example, the machine learning unit 30 generates the machine learning model that is trained to predict the calculation result of the simulator by training the relationship between an input condition that is used in the simulator and an output result obtained from the simulator. For example, the machine learning unit 30 acquires information related to the combination of "the road network, the traffic demand, and the measure data" that are the input condition for the traffic simulator and the "traffic density" that is the output result obtained by the simulator. Then, the machine learning unit 30 generates the surrogate model 13 by performing the machine learning by using the combination of "the road network, the traffic demand, and the measure data" as the objective variable and using the "traffic density" as the explanatory variable. As a result of this, the machine learning unit 30 generates the surrogate model 13 that is the machine learning model that is used to substitute the simulation.

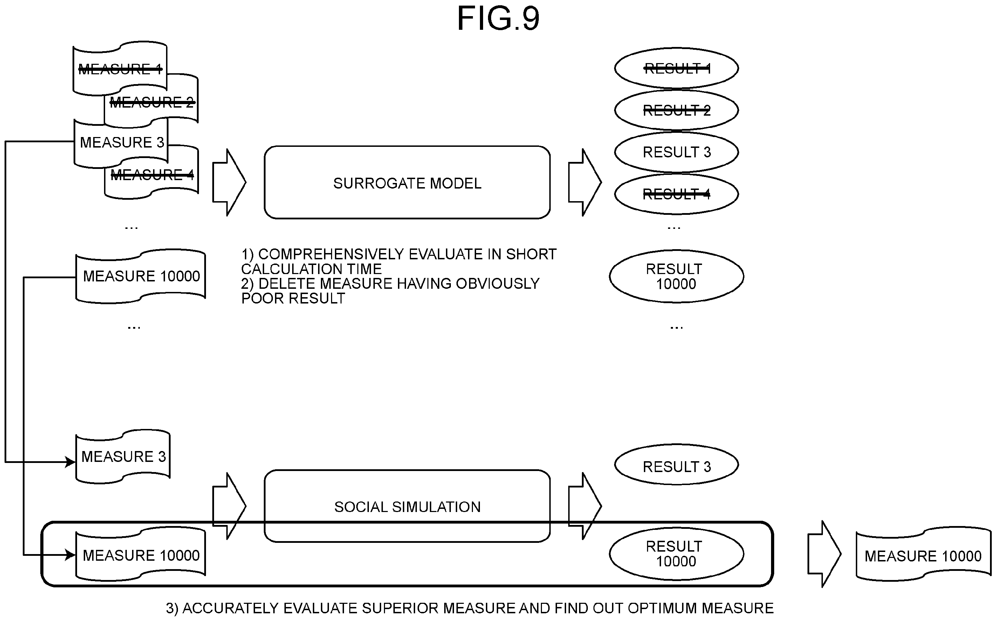

The prediction processing unit 40 is a processing unit that includes a filtering unit 41 and a specifying unit 42 and that performs the measure optimization system that is used to specify an optimum measure from the plurality of measures. FIG. 9 is a diagram illustrating a prediction process. For example, as illustrated in FIG. 9, the prediction processing unit 40 comprehensively evaluates a measure in a short calculation time by performing pre-filtering on the measures of the measure 1 to the measure 10000 that are evaluation target by using the surrogate model 13, and deletes a measure that is an obviously poor result. After that, the prediction processing unit 40 operates a traffic simulator to simulate each of a measure 3 or the measure 10000 of which evaluation obtained by the surrogate model 13 is not poor, and specifies the optimum measure 10000 by accurately evaluating a superior measure.

The filtering unit 41 is a processing unit that performs filtering on the plurality of measures by using the surrogate model 13. Specifically, the filtering unit 41 inputs the plurality of measures to the surrogate model 13, and determines, on the basis of the output result obtained by the surrogate model 13, whether each of the plurality of measures is in the interpolation area or in the extrapolation area.

For example, as uncertainty of the prediction result obtained by the surrogate model is higher, the measure is likely to be present in the extrapolation area. Accordingly, the filtering unit 41 measures entropy as the uncertainty of the prediction result, and determines that the measure having high entropy is in the extrapolation area.

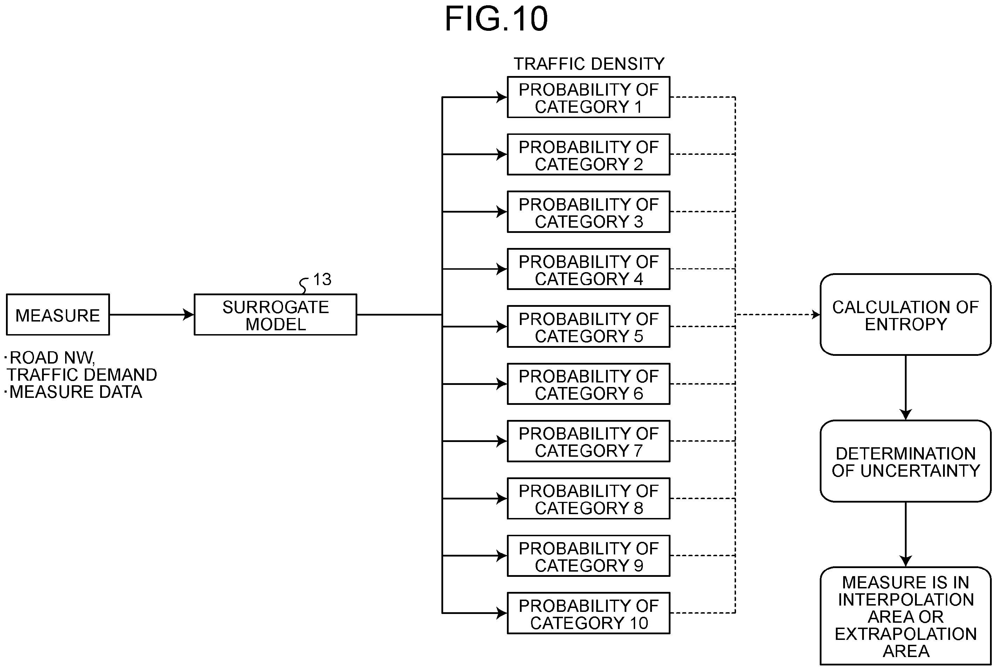

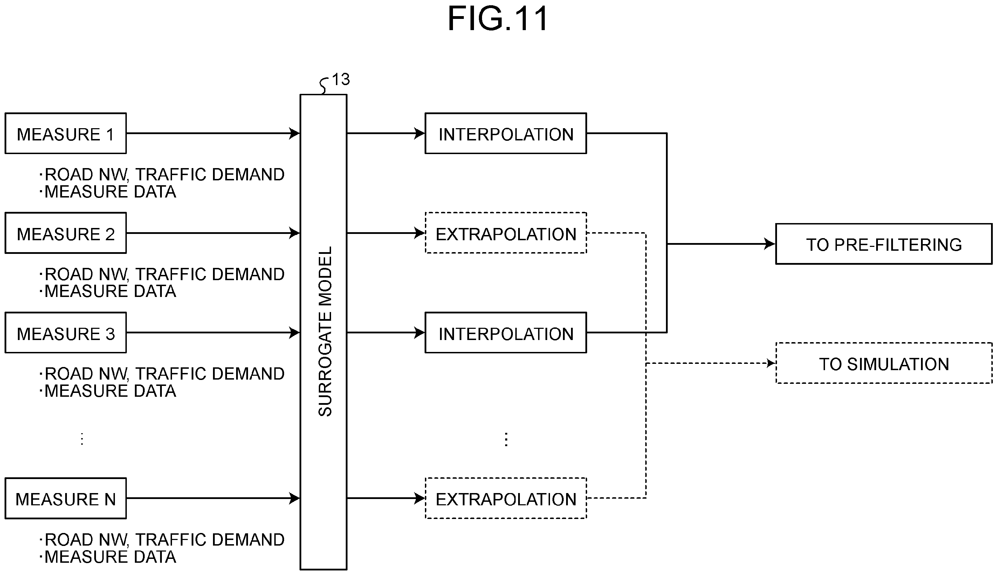

FIG. 10 and FIG. 11 are diagrams each illustrating pre-filtering performed by the surrogate model 13. In FIG. 10, the traffic density of each of the roads is predicted by using 10 levels (a level of non-congestion to a level of congestion). In other words, the surrogate model 13 based on a neural network solves a problem that the traffic density indicated at the time of performing a measure is determined to be which of the 10 categories.

As illustrated in FIG. 10, the filtering unit 41 inputs the measure including a road NW, a traffic demand, and the measure data to the surrogate model 13. The surrogate model 13 outputs information indicating that the traffic density of each of the road belongs which category by using probability. For example, in a case of an input x, and a category y (y 6 {1, 2, ... , and 10}) that is a congestion degree, an output of the surrogate model 13 is $P_{it}(y|x)$. Here, $P_{it}(y|x)$ indicates the probability that the congestion degree of the road i is y at a clock time t when the traffic demand is x.

Subsequently, the filtering unit 41 calculates entropy by inputting a probability value of each of the categories to Equation (1). Then, by using uses Equation (2), the filtering unit 41 calculates entropy corresponding to uncertainty of a prediction by taking the average of all of the roads denotes all of the clock time. Furthermore, the sigma symbol indicated in an inner side of Equation (2) denotes the sum of all of the roads, whereas the sigma symbol indicated in an outer side of Equation (2) denotes the sum of all of the clock time, and T denotes the number of increments of the clock time (t 6 {1, 2, ... , and T}), and I denotes the number of roads (i 6 {1, 2, ... , and I}).

$$E_{it} = -\sum_{y \in \{1,2,3,\cdots,10\}} P_{it}(y|x) \cdot \log P_{it}(y|x) \tag{1}$$

#Σtakes the sum of all categories.

$$U = \frac{1}{TI}\sum_{t \in \{1,2,3,\cdots,T\}} \sum_{i \in \{1,2,3,\cdots,I\}} E_{it} \tag{2}$$

After that, in a case where uncertainty U is equal to or greater than a threshold δ, the filtering unit 41 determines that the subject measure is a measure belonging to an extrapolation area, whereas, in a case where the uncertainty U is less than the threshold δ, the filtering unit 41 determines that the subject measure is a measure belonging to an interpolation area. Furthermore, the threshold δ is experimentally decided in accordance with a case.

For example, as illustrated in FIG. 11, the filtering unit 41 determines uncertainty of each of the measures by inputting each of the measures corresponding to the measure 1 to the measure N to the surrogate model 13. Then, the filtering unit 41 determines that the measure 1, the measure 3, and the like belong to the interpolation area and correspond to a pre-filtering target, and determines that the measure 2, the measure N, and the like belong to the extrapolation area and correspond to a target that is out of the pre-filtering target and only for a traffic simulation.

A description will be given here by referring back to FIG. 7. The specifying unit 42 is a processing unit that specifies a measure corresponding to the implementation target from among the plurality of measures that are the consideration targets on the basis of the result obtained from one or more simulations (traffic simulator) that have been subjected to the filtering process by the filtering unit 41. Specifically, regarding the measures belonging to the interpolation area, the specifying unit 42 narrows down the subject measures at the time of an output from the surrogate model 13, and performs the traffic simulator only to the narrowed down measures. In contrast, regarding the measures belonging to the extrapolation area, the specifying unit 42 does not perform the narrowing process at the time of an output from the surrogate model 13, but performs the traffic simulator on all of the measures. Then, the specifying unit 42 specifies an optimum measure (traffic measure) on the basis of the result obtained by the traffic simulator.

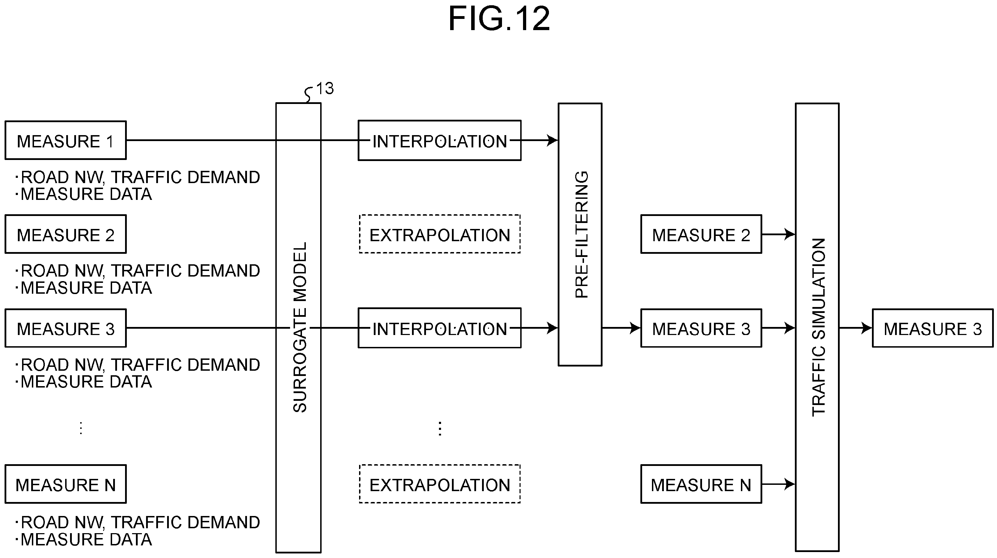

FIG. 12 is a diagram illustrating a process of specifying a measure by the simulation. As illustrated in FIG. 12, regarding the measure 1 and the measure 3 that are determined to belong to the interpolation area by the surrogate model 13, the specifying unit 42 determines whether or not the measure 1 and the measure 3 are the simulation targets on the basis of the output result obtained by the surrogate model 13. In the above described example, in a case where it is estimated that the measure 1 has a traffic density 7, and the measure 3 has a traffic density 7 from among the 10 levels of the traffic density, the specifying unit 42 decides the measure 3 corresponding to the level less than the threshold (a traffic density 5) to be the simulation target.

After that, the specifying unit 42 performs the traffic simulation on the measure 3 that acquires a high evaluation by the surrogate model 13 from among the measures that are determined to belong to the interpolation area by the surrogate model 13 and performs the traffic simulation on each of the measure 2 and the measure N that are determined to belong to the extrapolation area by the surrogate model 13. Then, the specifying unit 42 determines the measure 3 that has the lowest traffic density, in other words, that has less expected congestion to be an optimal solution from among the results obtained from the traffic simulation performed on each of the measure 2, the measure 3, and the measure N. Furthermore, the specifying unit 42 displays the measure 3 that has been decided to be the optimal solution on a display, or the like, or transmits the measure 3 to a terminal or the like that is assigned by an administrator, or the like.

Flow of process

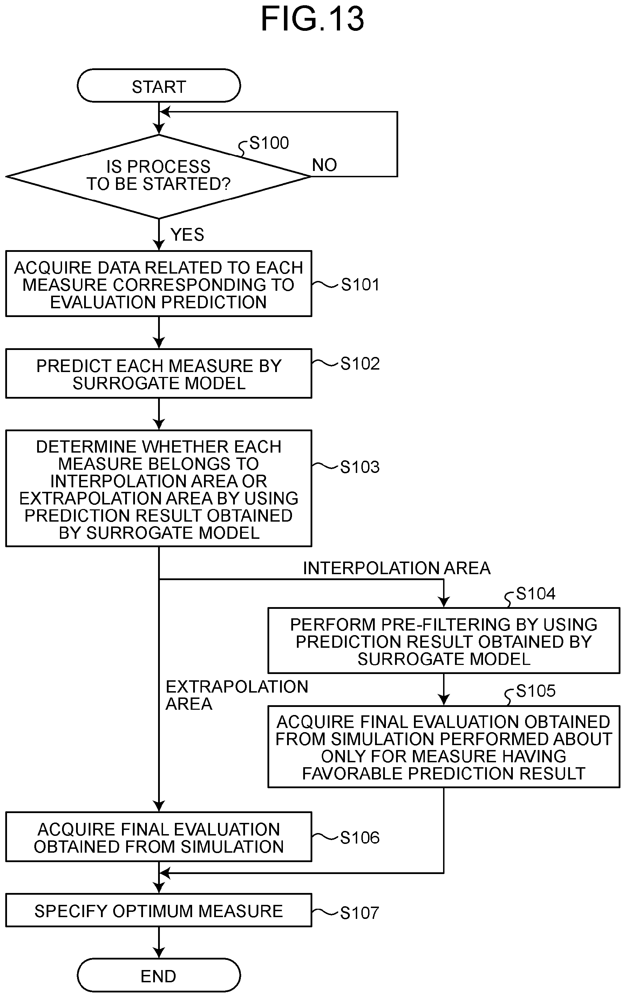

FIG. 13 is a flowchart illustrating the flow of the measure optimization system. Furthermore, here, it is assumed that surrogate model 13 has been trained.

As illustrated in FIG. 13, the information processing apparatus 10 determines whether or not a process is to be started. The information processing apparatus 10 determines whether or not the process is to be started on the basis of, for example, whether or not an instruction to start the process is received (Step S100). If the process is not started (No at Step S100), the information processing apparatus 10 receives the instruction to start the process. On the other hand, if the process has been started (Yes at Step S100), the information processing apparatus 10 acquires each of the measures targeted for the evaluation prediction. For example, the information processing apparatus 10 acquires the data that is related to the measure corresponding to the target for the evaluation prediction (Step S101).

Subsequently, the information processing apparatus 10 predicts the traffic density at the time of execution of each of the measures via the surrogate model 13. For example, the information processing apparatus 10 acquires the prediction result (traffic density) that is output by the surrogate model 13 by inputting the data related to the measures to the surrogate model 13 (Step S102).

Subsequently, the information processing apparatus 10 determines whether or not each of the measures belongs to the interpolation area or the extrapolation area by using the prediction result (traffic density) of each of the measures. For example, the information processing apparatus 10 determines whether the data related to the measure belongs to the interpolation area or the extrapolation area on the basis of the prediction result (traffic density) obtained by the surrogate model 13. More specifically, for example, the information processing apparatus 10 determines whether the data related to the measure is within the range or without the range of the learning data distribution obtained by the surrogate model 13, on the basis of the prediction probability obtained from the prediction result (traffic density) (Step S103).

Then, if it is determined that the data related to the measure belongs to the interpolation area (Step S103: interpolation area), the information processing apparatus 10 performs pre-filtering on each of the measures that have been determined to belong to the interpolation area by using the prediction result obtained by the surrogate model (Step S104). Subsequently, the information processing apparatus 10 acquires, from the simulation, a final evaluation about only the measure that has a favorable prediction result obtained by the surrogate model 13 (Step S105).

In contrast, if it is determined that the data related to the measure belongs to the extrapolation area (Step S103: extrapolation area), the information processing apparatus 10 acquires, from the simulation, the final evaluation without performing pre-filtering on each of the measures that are determined to belong to the extrapolation area by using the prediction result obtained by the surrogate model (Step S106).

Then, the information processing apparatus 10 specifies an optimum measure with respect to a condition that the traffic density is low, or the like from the simulation result related to each of the measures (Step S107).

Effects

As described above, the information processing apparatus 10 is able to increase the calculation efficiency by performing pre-filtering on the candidate measures by utilizing the characteristics of the surrogate model 13 and is able to perform the prediction with high accuracy by utilizing the characteristics of the simulation. As a result of this, the information processing apparatus 10 is able to find an optimum measure in a short time.

Furthermore, the information processing apparatus 10 performs determination of the interpolation area and the extrapolation area by utilizing the characteristics of the surrogate model 13. As a result of this, the information processing apparatus 10 is able to perform accurate determination without depending on the type of each of the measures and the other information, and is able to suppress a decrease in accuracy as a result of long search time needed for an optimum measure due to the type, or the like of the measures.

Furthermore, the information processing apparatus 10 is able to implement both of speeding up a process and high accuracy by evaluating the measures at the plurality of levels. As a result of this, it is possible to apply, without anxiety, the social measure usually having special circumstances that there is no room for failure, or the like.

(b) Second Embodiment

Incidentally, the determination of the interpolation area and the extrapolation area performed by the surrogate model 13 often relies on the learning data for the surrogate model 13, and, if the extrapolation area is too broad, the range to be evaluated by the simulation increases. Therefore, it is conceivable to reduce the calculation time. Accordingly, in a second embodiment, technical ingenuity in broadening the interpolation area for the surrogate model 13 will be described.

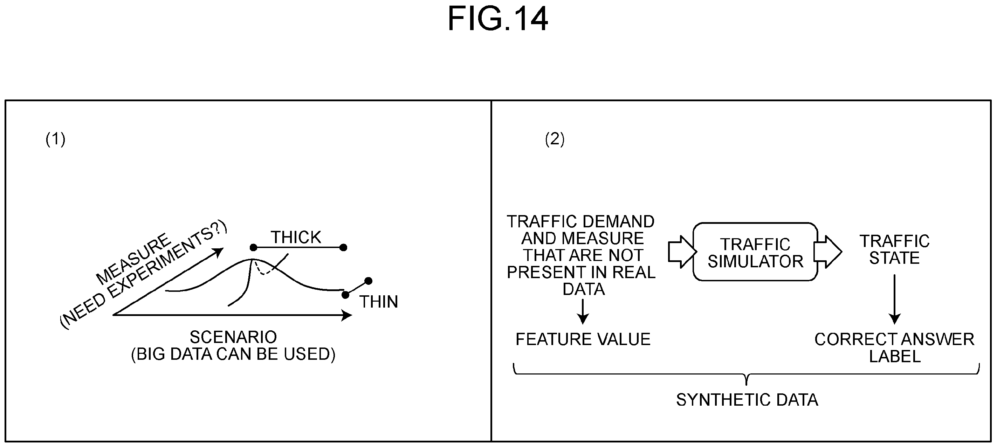

First, an augmentation technique that is often used for learning data will be described. FIG. 14 is a diagram illustrating an example of an augmentation of learning data that is used for the surrogate model 13. The diagram indicated by (1) illustrated in FIG. 14 indicates a design example of a learning data set. In general, it is conceivable to broaden the interpolation area by increasing a learning target by increasing the breadth of the distribution of the learning data set. For example, a large amount of learning data with respect to a predictable scenario, such as the Golden Week or the New Year vacation, is present as past data, so that it is possible to easily collect this type of learning data.

However, in many cases, data on various measures is not present, and thus, it is hard to say that this technique is suitable for the social measure having special circumstances that there is no room for failure, or the like. For example, regarding a railroad station that is newly construct at the time of the Olympic or an operation of a shuttle bus, it is not possible to collect past data no matter how much data (real data) is examined, and therefore, the interpolation area is not appropriately broaden.

Furthermore, the diagram indicated by (2) illustrated in FIG. 14 indicates data augmentation obtained by synthetic data. With the collection technique used for the past data indicated by (1) illustrated in FIG. 14, in a case where there is a limit to increase the breadth of the distribution of the data set, it is conceivable to perform data augmentation by using data (synthetic data) that is artificially generated. For example, a traffic state (traffic density) is calculated by inputting a traffic demand and a measure that is not present in the real data to a traffic simulator. Then, the synthetic data in which the input data of "the traffic demand or the measure" is used as an explanatory variable (feature value) and the output traffic state is used as a correct answer label.

However, as described above in the first embodiment, the calculation cost is high in order to generate data by a simulation. In other words, it takes an immense amount of time to generate a sufficient amount of synthetic data, which is not realistic.

Solution 1

Accordingly, the information processing apparatus 10 according to the second embodiment generates synthetic data by using theoretical model whose calculation cost is less expensive than that of the simulation model, and uses the obtained synthetic data as the learning data that is used for the surrogate model 13.

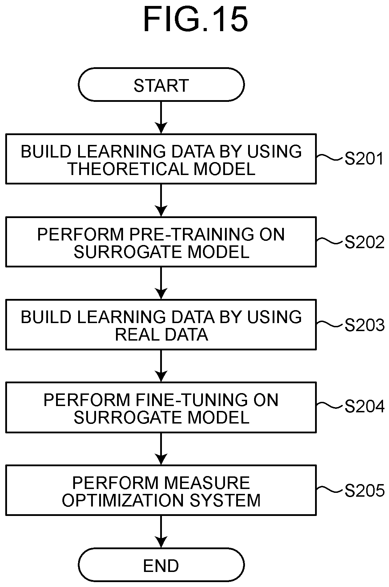

FIG. 15 is a diagram illustrating a learning process 1 that improves the accuracy of the surrogate model. As illustrated in FIG. 15, the machine learning unit 30 included in the information processing apparatus 10 builds the learning data that is the augmented data by using the theoretical model (Step S201), and performs pre-training on the surrogate model 13 by using the obtained learning data (Step S202).

Then, the machine learning unit 30 builds the learning data by using the real data that is the past data that has been prepared in advance (Step S203), and performs, by using the obtained learning data, fine-tuning on the surrogate model 13 that has been trained by the augmented data (Step S204). After that, the information processing apparatus 10 performs the measure optimization system illustrated in FIG. 13 by using the surrogate model 13 that has been subjected to the fine-tuning (Step S205).

For example, in a case where a traffic is reproduced, a theoretical model for a traffic flow is used. Specifically, the machine learning unit 30 calculates an equilibrium flow under a predetermined traffic demand by using a Static Traffic Assignment model. Then, the machine learning unit 30 generates the learning data (theoretical value) in which the input traffic demand is used as an explanatory variable (feature value) and the equilibrium flow is used as a correct answer data. The machine learning unit 30 trains the actual traffic data as a difference therebetween after having training in advance by the above described theoretical value. In this way, the information processing apparatus 10 is able to calculate the equilibrium flow at high speed by using the above described theoretical model, and is able to improve the accuracy of the area in which the actual traffic data is insufficient.

Solution 2

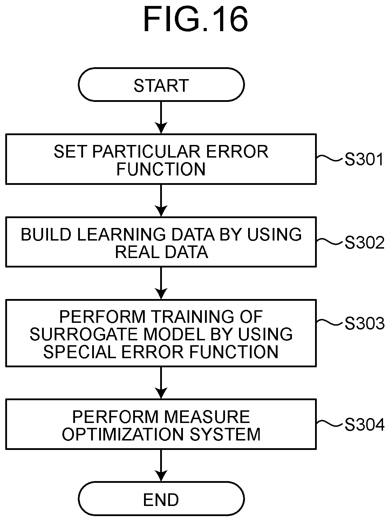

For example, the information processing apparatus 10 according to the second embodiment focuses on the low of the target domain of the surrogate model 13, and builds a model conforming to not only the learning data but also the low. FIG. 16 is a diagram illustrating a learning process 2 that improves the accuracy of the surrogate model.

As illustrated in FIG. 16, the machine learning unit 30 sets a special error function that is an error function that evaluates not only a degree of coincidence with the learning data but also a degree of coincidence with the low of the target domain (Step S301), builds the learning data by using the real data that is the past data that has been prepared in advance (Step S302), and uses the built learning data and performs training of the surrogate model 13 by using both of the special error function and the learning data (Step S303). After that, the information processing apparatus 10 performs the measure optimization system illustrated in FIG. 13 by using the trained surrogate model 13 (S304).

For example, in a case where a traffic is reproduced, the low related to the traffic flow is focused on. Specifically, the machine learning unit 30 focuses on fulfilling the flow conservation law by each of the intersection points, and designs an error function in which a penalty becomes large as the output result obtained by the surrogate model 13 deviates away from the learning data, and also, deviates away from the flow conservation law. Furthermore, the flow conservation law mentioned here is a low in which the sum of the inflow and outflow of the traffic to each of the intersection points indicates zero. In this way, the machine learning unit 30 is able to build the model that is also conforms to the flow conservation law by training the surrogate model 13 using this error function. As a result of this, the information processing apparatus 10 is able to allow a behavior exhibited in the area in which the real data is insufficient be consistent with an experience. Accordingly, the information processing apparatus 10 is able to implement the process with high accuracy.

By carrying out the solution 1 or the solution 2 for broadening the interpolation area described above, it is possible to broaden an applicable range of the pre-filtering performed by the surrogate model 13, and it is thus possible to further enhance the calculation efficiency than that provided in the first embodiment.

(c) Third Embodiment

In the above explanation, a description has been given of the embodiments according to the present invention; however, the present invention may also be implemented with various kinds of embodiments other than the embodiments described above.

Numerical value, etc.

The numerical value, the data, and the like that are used in the embodiment described above are only examples and may be arbitrarily changed. Furthermore, the flow of the processes descried in each of the flowcharts may be appropriately changed as long as the processes do not conflict with each other.

OD table

In the above described embodiment, the OD table in which dimensions of the "departure point", the "arrival point", and the "clock time" are used as traffic demand, and the OD table in which dimensions of the "intersection point", the "number of vehicles passing through the intersection point", and the "clock time" are used as the simulation result (traffic state) are used as an example, but the example is not limited to this. For example, the data format is not limited to the matrix format, such as the OD table, it may be possible to use various data formats, such as a table format, an arbitrary data format, a three-dimensional graphical format, and an Extensible Markup Language (XML) format.

Digital twin

Furthermore, the information processing apparatus 10 is also able to perform a simulation using a digital twin that virtually reproduces a traffic flow of the same time in the real world as one example of the traffic simulator that performs the traffic simulation.

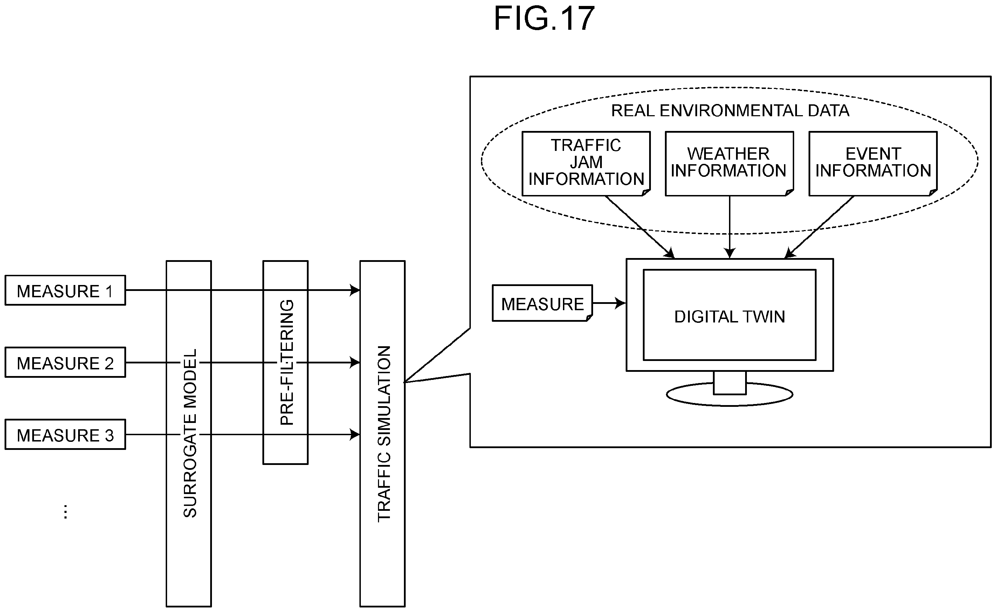

FIG. 17 is a diagram illustrating an example in which a digital twin is used. As illustrated in FIG. 17, the information processing apparatus 10 reproduces, on the digital twin, real environmental data, such as traffic jam information, weather information, and event information related to the corresponding area. More specifically, the information processing apparatus 10 forms a digital twin obtained by virtually reproducing a traffic flow at the same clock time in the real world by performing time synchronization with, for example, a real space on a virtual space. Then, the information processing apparatus 10 performs a simulation on each of the measures, and is able to specify, by using each of the simulation results, a measure that is able to be optimized by using the same method as that used in the first embodiment. As a result of this, the information processing apparatus 10 is able to specify a measure having high reproducibility in addition to high reliability and high feasibility.

System

The flow of the processes, the control procedures, the specific names, and the information containing various kinds of data or parameters indicated in the above specification and drawings can be arbitrarily changed unless otherwise stated. Furthermore, specific examples, distributions, numerical values, and the like described in the embodiment are only examples and can be arbitrarily changed.

Furthermore, the specific shape of a separate or integrated device is not limited to the drawings. For example, the machine learning unit 30 and the prediction processing unit 40 may be integrated. In other words, all or part of the device can be configured by functionally or physically separating or integrating any of the units in accordance with various loads or use conditions. In addition, all or any part of each of the processing functions of the respective devices can be implemented by a CPU and by programs analyzed and executed by the CPU or implemented as hardware by wired logic.

In addition, all or any part of each of the processing functions performed by the each of the devices can be implemented by a CPU and by programs analyzed and executed by the CPU or implemented as hardware by wired logic.

Hardware

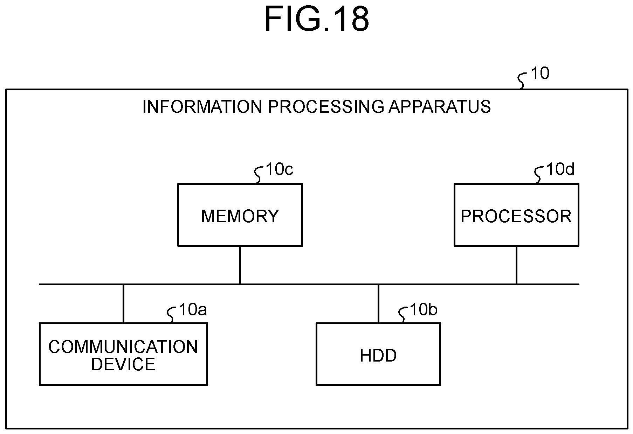

FIG. 18 is a diagram illustrating an example of a hardware configuration. As illustrated in FIG. 18, the information processing apparatus 10 includes a communication device 10a, a hard disk drive (HDD) 10b, a memory 10c, and a processor 10d. Furthermore, each of the units illustrated in FIG. 18 is connected each other via a bus or the like.

The communication device 10a is a network interface card or the like, and communicates with another server. The HDD 10b stores therein programs or the DB that operates the function illustrated in FIG. 7.

The processor 10d operates the process that executes each of the functions described above in FIG. 7 or the like by reading the programs that execute the same process as that performed by each of the processing units illustrated in FIG. 7 from the HDD 10b or the like and loading the read program in the memory 10c. For example, the process executes the same function as that performed by each of the processing units included in the information processing apparatus 10. Specifically, the processor 10d reads, from the HDD 10b or the like, the programs having the same function as that performed by each of the machine learning unit 30, the prediction processing unit 40, and the like. Then, the processor 10d executes the process for executing the same process as that performed by each of the machine learning unit 30, the prediction processing unit 40, and the like.

In this way, the information processing apparatus 10 is operated as an information processing apparatus that executes measure optimization by reading and executing the programs. In addition, the information processing apparatus 10 is also able to implement the same function as that described above in the embodiment by reading the programs described above from a recording medium by a medium recording device and executing the read programs described above. In addition, the programs described in another embodiment are not limited to be executed by the information processing apparatus 10. For example, the embodiment described above may also be similarly used in a case in which another computer or a server executes a program, or in a case in which another computer and a server cooperatively execute the program with each other.

The programs may be distributed via a network, such as the Internet. Furthermore, the programs may be executed by storing the programs in a recording medium that can be read by a computer readable medium, such as a hard disk, a flexible disk (FD), a CD-ROM, a magneto-optical disk (MO), a digital versatile disk (DVD), or the like, and read the programs from the recording medium by the computer.

According to an aspect of one embodiment, it is possible to improve selection accuracy of a measure.

**Claims**

1. A measure specifying program that causes a computer (10) to execute a process comprising:

   receiving (S101) data for a plurality of social measures that is a consideration target;
   detecting (S102) a prediction model constructed from a trained neural network for substituting a simulation related to social measures by using machine learning;
   performing (S102, S103, S104), based on characteristics of the prediction model, a filtering processing on the data for the plurality of social measures;
   performing (S105) the simulation on data for one or more of the social measures extracted by the filtering processing;
   specifying (S107), based on a result of the simulation performed on the data for the one or more social measures, a first social measure that is an implementation target from among the plurality of social measures that is the consideration target; and
   outputting (S107) the first social measure.

2. The non-transitory computer-readable recording medium according to claim 1, wherein

   the trained neural network is trained to output traffic density for each link of a road network in response to inputs of parameters related to the road network and traffic demand, and policy variables related to event traffic demand, and
   the specifying includes specifying the data for one or more of the social measures in which the traffic density outputted by the prediction model is equal to or less than a threshold value.

3. The measure specifying program according to claim 1, wherein the process further includes:

   acquiring (S101), by using the prediction model that has been trained by machine learning, from among the social measures that are the consideration target, a measure relevant to learning data obtained by training the prediction model;
   evaluating (S102), by using the prediction model, the acquired measure relevant to the learning data; and
   performing (S106) the simulation on the social measures based on an evaluation result obtained by the prediction model.

4. The measure specifying program according to claim 1, wherein the process further includes:

   analyzing (S103) a distribution of learning data that is used for the prediction model and that is generated from past data;
   determining (S103) whether or not the social measure to be evaluated is within or without a range of the distribution of the learning data used for the prediction model;
   re-evaluating (S104, S105), when the social measure to be evaluated is within the range of the distribution of the learning data, only the measure in which a prediction result obtained by the prediction model is high by performing the simulation that has been performed on the social measures after having evaluated the social measures by using the prediction model; and
   evaluating (S106), when the social measure to be evaluated is without the range of the distribution of the learning data, the measure by performing the simulation that has been performed on the social measures.

5. The measure specifying program according to claim 1, wherein the process further includes:

   generating (S201) augmented data that has been theoretically calculated by using a theoretical model;
   performing (S202) machine learning on a surrogate model by using the augmented data as learning data; and
   performing fine-tuning (S203, S204), by using learning data that has been generated from past data, on the surrogate model that has been trained by using the augmented data, wherein
   the filtering (S205) performs the filtering on the plurality of social measures that is the consideration target based on the characteristics of the surrogate model that is obtained after the fine-tuning.

6. The measure specifying program according to claim 5, wherein

   the plurality of social measures is measure data for preventing an occurrence of or an increase in congestion in a link between nodes in a road network in a predetermined area, and
   the theoretical model (13) is a theoretical model for calculating an equilibrium flow under a predetermined traffic demand.

7. The measure specifying program according to claim 1, wherein the process further includes:

   performing (S301, S302, S303) machine learning on a surrogate model by using learning data that has been generated from past data and using an error function for evaluating a degree of coincidence with the learning data and a degree of coincidence with a low of a target domain, wherein
   the filtering (S104) performs the filtering on the plurality of social measures that is the consideration target based on the characteristics of the surrogate model that has been trained by using the learning data and the error function.

8. The measure specifying program according to claim 7, wherein

   the plurality of social measures is measure data for preventing an occurrence of or an increase in congestion in a link between nodes in a road network in a predetermined area, and
   the error function is an error function that satisfies the degree of coincidence with the learning data and a flow conservation law related to an outflow of a traffic to an intersection point included in the road network.

9. The measure specifying program according to claim 1, wherein

   the performing the filtering (S104) includes

acquiring a plurality of pieces of social measure data corresponding to candidates applied to a predetermined area, and

performing the filtering on the acquired plurality of social measure data by using the prediction model that has been trained by machine learning, and

the specifying (S107) includes

predicting, by using a simulator, a state of the predetermined area indicating a result of the simulation related to one or more pieces of the social measure data that have been subjected to the filtering, and

specifying, based on the predicted state of the predetermined area, the social measure data that is applied to the predetermined area.

10. The measure specifying program according to claim 9, wherein

the prediction model (13) is a machine learning model for substituting a simulation obtained by a traffic simulator, the social measure data is data that indicates a traffic measure applied to the predetermined area and that indicates a measure for resolving a congestion degree in the predetermined area, the simulation of the social measure data predicts the congestion degree in the predetermined area by using the traffic simulator, and the simulation specifies the social measure data to be applied to the predetermined area based on the calculated congestion degree.

11. The measure specifying program according to claim 9, wherein the predicting includes calculating a degree of congestion in the predetermined area based on a result obtained from a simulation performed on a digital twin that is obtained by reproducing a traffic flow at the same clock time in the real world onto a virtual space.

12. A measure specifying method carried out by a computer (10), comprising:

receiving (S101) data for a plurality of social measures that is a consideration target; detecting (S102) a prediction model constructed from a trained neural network for substituting a simulation related to social measures by using machine learning; performing (S102, S103, S104), based on characteristics of the prediction model, a filtering processing on the data for the plurality of social measures; performing (S105) the simulation on data for one or more of the social measures extracted by the filtering processing; specifying (S107), based on a result of the simulation performed on the data for the one or more social measures, a first social measure that is an implementation target from among the plurality of social measures that is the consideration target; and outputting (S107) the first social measure.

13. An information processing apparatus that includes a control unit (20) configured to perform a process comprising:

receiving (S101) data for a plurality of social measures that is a consideration target; detecting (S102) a prediction model constructed from a trained neural network for substituting a simulation related to social measures by using machine learning; performing (S102, S103, S104), based on characteristics of the prediction model, a filtering processing on the data for the plurality of social measures; performing (S105) the simulation on data for one or more of the social measures extracted by the filtering processing; specifying (S107), based on a result of the simulation performed on the data for the one or more social measures, a first social measure that is an implementation target from among the plurality of social measures that is the consideration target; and outputting (S107) the first social measure.

# FIG.1

INFORMATION PROCESSING APPARATUS — 10

MEASURE 1
·ROAD NW, TRAFFIC DEMAND
·MEASURE DATA

MEASURE 2
·ROAD NW, TRAFFIC DEMAND
·MEASURE DATA

⋮

MEASURE N
·ROAD NW, TRAFFIC DEMAND
·MEASURE DATA

EVALUATION

EVALUATION 1

EVALUATION 2

⋮

EVALUATION N

SELECTION

MEASURE INFORMATION 2

EP 4 614 410 A1

# FIG.2

ROAD NETWORK

n1
e1
n6 n2
e2
e7 n3
e6 e5 e4 e3
n7 n5 n4
e8 n8
e9
n9

INPUT → SIMULATION → OUTPUT

TRAFFIC DEMAND

TRAVEL DEMAND (OD TABLE) BETWEEN EACH POINT

DEPARTURE POINT (ORIGIN)

| | ARRIVAL POINT (DESTINATION) | | | | |
|---|---|---|---|---|---|
| | n1 | n2 | n3 | n4 | ... |
| n1 | – | 5 VE-HICLES | 20 VE-HICLES | 20 VE-HICLES | ... |
| n2 | 10 VE-HICLES | – | 5 VE-HICLES | 30 VE-HICLES | ... |
| n3 | 5 VE-HICLES | 5 VE-HICLES | – | 10 VE-HICLES | ... |
| n4 | 50 VE-HICLES | 10 VE-HICLES | 5 VE-HICLES | – | ... |
| ... | ... | ... | ... | ... | ... |

CLOCK TIME

9:00   9:10   9:20   ...

TRAFFIC STATE

TRAFFIC VOLUME ON EACH ROAD

| e1 | e2 | e3 | e4 | ... |
|---|---|---|---|---|
| 45 VE-HICLES | 35 VE-HICLES | 10 VE-HICLES | 5 VE-HICLES | ... |

CLOCK TIME

EP 4 614 410 A1

# FIG.3

# FIG.4

# FIG.5

| | | | SIM RESULT | SM RESULT |
|---|---|---|---|---|
| MEASURE 1 | | RESULT 1 | -- | ++ |
| MEASURE 2 | | RESULT 2 | - | - |
| MEASURE 3 | SURROGATE MODEL | RESULT 3 | + | + |
| MEASURE 4 | | RESULT 4 | -- | - |
| ... | | ... | | |
| MEASURE 10000 | | RESULT 10000 | ++ | + |
| ... | | ... | | |

EP 4 614 410 A1

# FIG.6

EP 4 614 410 A1

# FIG.7

INFORMATION PROCESSING APPARATUS — 10

COMMUNICATION UNIT — 11

CONTROL UNIT — 20

MACHINE LEARNING UNIT — 30

PREDICTION PROCESSING UNIT — 40

FILTERING UNIT — 41

SPECIFYING UNIT — 42

STORAGE UNIT — 12

SURROGATE MODEL — 13

SIMULATION INFORMATION — 14

EP 4 614 410 A1

# FIG.8

LEARNING DATA

EXPLANATORY VARIABLE

ROAD NETWORK + TRAFFIC DEMAND (FORECAST VALUE)+ MEASURE DATA

OBJECTIVE VARIABLE

TRAFFIC DENSITY

13

SURROGATE MODEL → PREDICTION RESULT

ERROR INFORMATION

EP 4 614 410 A1

# FIG.9

MEASURE 1 (struck through)
MEASURE 2 (struck through)
MEASURE 3
MEASURE 4 (struck through)
...
MEASURE 10000
...

SURROGATE MODEL

RESULT 1 (struck through)
RESULT 2 (struck through)
RESULT 3
RESULT 4 (struck through)
...
RESULT 10000
...

1) COMPREHENSIVELY EVALUATE IN SHORT CALCULATION TIME
2) DELETE MEASURE HAVING OBVIOUSLY POOR RESULT

MEASURE 3
MEASURE 10000

SOCIAL SIMULATION

RESULT 3
RESULT 10000

MEASURE 10000

3) ACCURATELY EVALUATE SUPERIOR MEASURE AND FIND OUT OPTIMUM MEASURE

EP 4 614 410 A1

# FIG.10

TRAFFIC DENSITY

MEASURE → SURROGATE MODEL (13)

·ROAD NW, TRAFFIC DEMAND
·MEASURE DATA

- PROBABILITY OF CATEGORY 1
- PROBABILITY OF CATEGORY 2
- PROBABILITY OF CATEGORY 3
- PROBABILITY OF CATEGORY 4
- PROBABILITY OF CATEGORY 5
- PROBABILITY OF CATEGORY 6
- PROBABILITY OF CATEGORY 7
- PROBABILITY OF CATEGORY 8
- PROBABILITY OF CATEGORY 9
- PROBABILITY OF CATEGORY 10

CALCULATION OF ENTROPY → DETERMINATION OF UNCERTAINTY → MEASURE IS IN INTERPOLATION AREA OR EXTRAPOLATION AREA

EP 4 614 410 A1

# FIG.11

# FIG.12

EP 4 614 410 A1

# FIG.13

START

S100
IS PROCESS TO BE STARTED? — NO

YES

ACQUIRE DATA RELATED TO EACH MEASURE CORRESPONDING TO EVALUATION PREDICTION — S101

PREDICT EACH MEASURE BY SURROGATE MODEL — S102

DETERMINE WHETHER EACH MEASURE BELONGS TO INTERPOLATION AREA OR EXTRAPOLATION AREA BY USING PREDICTION RESULT OBTAINED BY SURROGATE MODEL — S103

INTERPOLATION AREA

S104
PERFORM PRE-FILTERING BY USING PREDICTION RESULT OBTAINED BY SURROGATE MODEL

EXTRAPOLATION AREA

S105
ACQUIRE FINAL EVALUATION OBTAINED FROM SIMULATION PERFORMED ABOUT ONLY FOR MEASURE HAVING FAVORABLE PREDICTION RESULT

ACQUIRE FINAL EVALUATION OBTAINED FROM SIMULATION — S106

SPECIFY OPTIMUM MEASURE — S107

END

# FIG.14

(1)

MEASURE
(NEED EXPERIMENTS?)

THICK

THIN

SCENARIO
(BIG DATA CAN BE USED)

(2)

TRAFFIC DEMAND AND MEASURE THAT ARE NOT PRESENT IN REAL DATA → TRAFFIC SIMULATOR ⇒ TRAFFIC STATE

FEATURE VALUE

CORRECT ANSWER LABEL

SYNTHETIC DATA

EP 4 614 410 A1

# FIG.15

```
        ┌─────────────┐
        │    START    │
        └─────────────┘
               │
               ▼
┌───────────────────────────────┐
│  BUILD LEARNING DATA BY USING  │ ～S201
│       THEORETICAL MODEL        │
└───────────────────────────────┘
               │
               ▼
┌───────────────────────────────┐
│   PERFORM PRE-TRAINING ON      │ ～S202
│       SURROGATE MODEL          │
└───────────────────────────────┘
               │
               ▼
┌───────────────────────────────┐
│  BUILD LEARNING DATA BY USING  │ ～S203
│          REAL DATA             │
└───────────────────────────────┘
               │
               ▼
┌───────────────────────────────┐
│    PERFORM FINE-TUNING ON      │ ～S204
│       SURROGATE MODEL          │
└───────────────────────────────┘
               │
               ▼
┌───────────────────────────────┐
│     PERFORM MEASURE            │ ～S205
│   OPTIMIZATION SYSTEM          │
└───────────────────────────────┘
               │
               ▼
        ┌─────────────┐
        │     END     │
        └─────────────┘
```

# FIG.16

START

↓

SET PARTICULAR ERROR
FUNCTION ~S301

↓

BUILD LEARNING DATA BY USING
REAL DATA ~S302

↓

PERFORM TRAINING OF
SURROGATE MODEL BY USING
SPECIAL ERROR FUNCTION ~S303

↓

PERFORM MEASURE
OPTIMIZATION SYSTEM ~S304

↓

END

# FIG.17

# FIG.18

INFORMATION PROCESSING APPARATUS 10

MEMORY 10c

PROCESSOR 10d

COMMUNICATION DEVICE 10a

HDD 10b

**EP 4 614 410 A1**

## EUROPEAN SEARCH REPORT

Application Number

EP 25 15 5970

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LI ZHENG ET AL: "Simulation-based optimization of large-scale dedicated bus lanes allocation: Using efficient machine learning models as surrogates", TRANSPORTATION RESEARCH PART C:EMERGING TECHNOLOGIES, PERGAMON, NEW YORK, NY, GB, vol. 143, 4 August 2022 (2022-08-04), XP087181161, ISSN: 0968-090X, DOI: 10.1016/J.TRC.2022.103827 [retrieved on 2022-08-04] * cf. sections 1, 4.1, 4.3.2, 4.5.2, 6.2 and 6.3. * | 1-13 | INV. G06Q10/0631 |
| T | Wikipedia: "Surrogate model", , 19 February 2024 (2024-02-19), XP093289294, Retrieved from the Internet: URL:https://en.wikipedia.org/w/index.php?title=Surrogate_model&oldid=1208790439 [retrieved on 2025-06-24] * cf. Applications on page 3 * | | |

TECHNICAL FIELDS SEARCHED (IPC)

G06Q

The present search report has been drawn up for all claims

| Place of search | Date of completion of the search | Examiner |
|---|---|---|
| Munich | 25 June 2025 | Reino, Bernardo |

EPO FORM 1503 03.82 (P04C01)

**EP 4 614 410 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023113928 A
- JP 2021157456 A
- JP 2022003451 A
- US 20180112498